# EUROPEAN PATENT SPECIFICATION

(11) **EP 3 030 356 B1**
(45) Date of publication and mention of the grant of the patent: **14.09.2022**
(21) Application number: 14834632.3
(22) Date of filing: 07.08.2014
(51) Int. Cl.: B08B 1/00, B08B 7/00

(54) **WORKING SURFACE CLEANING METHOD**
ARBEITSFLÄCHENREINIGUNGSVERFAHREN
PROCÉDÉ DE NETTOYAGE DE SURFACES DE TRAVAIL

(30) Priority: 07.08.2013 US 201313961127
(43) Date of publication of application: 15.06.2016
(73) Proprietor: International Test Solutions, LLC, Reno, NV 89502 (US)
(72) Inventor: HUMPHREY, Alan, E., Reno, NV 89511 (US); BROZ, Jerry, J., Longmont, CO 80503 (US); DUVALL, James, H., Reno, NV 89511 (US)
(74) Representative: Betten & Resch
(86) International application number: PCT/US2014/050165
(87) International publication number: WO 2015/021287

(56) References cited:
- EP-A1- 1 942 519
- JP-A- S63 204 728
- US-A- 5 690 749
- US-A- 6 019 663
- US-A1- 2005 001 645
- US-A1- 2006 065 290
- US-A1- 2010 258 144
- US-A1- 2012 048 298

## Description

### Priority Claims/Related Applications

This application is a continuation in part of and claims priority under 35 USC 120 to U.S. Patent Application No.: 13/912,840, filed June 7, 2013 and titled "Working Surface Cleaning System And Method" which is in turn a continuation of and claims priority under 35 USC 120 to U.S. Patent Application Serial No. 11/237,596, filed on September 27, 2005 and entitled "Cleaning Method" which in turn claims the benefit under 35 USC 119(e) to U.S. Provisional Patent Application Serial No. 60/614,073 filed of September 28, 2004.

### Field

The invention relates generally to a method for removing particles and other foreign matter from the working surface of a cleaning device which is used during semiconductor manufacturing and testing.

### Background

It is desirable to be able to clean the working surface of devices that are used for probe card cleaning and semiconductor hardware cleaning wafers which are used to remove debris from wafer handling equipment (such as robot arms and end effectors) and wafer stages (such as a wafer chuck, wafer tables and/or pre-align chucks). The foreign matter and particulates collected on the probe card cleaning and hardware cleaning wafers are removed by the particle removal device that allows the surface debris that has been collected and removed from a probe card or the wafer handling hardware to be collected and discarded.

It is desirable to provide a cleaning method that allows the use of the particle removal device to refresh the working surface without the use of an outside vendor or the use of a wet washing step as part of the cleaning process.

Thus, it is desirable to provide such as cleaning method and it is to this end that the invention is directed.

EP 1 942 519 A1 discloses that there are provided a transfer member provided with a cleaning function, which have excellent foreign matter removing performance and transfer performance, and which can remove foreign matters having a predetermined particle diameter with especially high efficiency.

US 6 019 663 A discloses that a system and method for cleaning probe pins on a probe card used in testing a semiconductor device during fabrication thereof. A ceramic cleaning wafer is utilized to clean the probe pins without having to remove the probe card from a production line.

US 5 690 749 A discloses that a method for removing particles begins by providing a substrate. The substrate contains one or more integrated circuit layers having a top surface. The particles are in contact with top surface. A tape comprising an adhesion layer and a carrier film is applied to the surface such that the adhesion layer is in contact with the particles.

JP S63 204728 enables any foreign particle to be removed completely by a method wherein adhesive rubber rollers are used to remove the foreign particle adhering to the package surface of semiconductor devices.

US 2012/048298 A1 discloses a medium for predictably cleaning the contact elements and support hardware of a tester interface, such as a probe card and a test socket.

### Brief Description of the Drawings

Figure 1 is a perspective view of a cleaning film polymer with protective liner and film backing;
Figure 2 is a flow chart showing process steps for the cleaning film as used in onprobe cleaning wafers or chuck cleaning wafers; and
Figures 3A - 3D are photographic representations of the application and removal of the cleaning film.

### Detailed Description of One or More Embodiments

The invention is directed to a method designed to nondestructively and non-invasively remove foreign matter and particulates from the working surfaces of cleaning devices that are used for probe card cleaning during semiconductor device testing. The cleaning method can also be used to remove foreign matter and particulates from the working surfaces of cleaning devices and wafers used for cleaning wafer handling hardware and wafer stages in front end of line (FEOL) equipment during semiconductor device manufacturing.

The probe card cleaning materials as described in prior art can consist of unfilled and particulate filled elastomers to provide abrasive properties for debris removal and surface tack properties to collect the dislodged debris.

Debris is removed from the wafer test probe pins through contact with probe card cleaning materials. After repeated use of the probe card cleaning material, dislodged debris accumulates on the cleaning device working surface reducing contact with the probes to be cleaned and therefore diminishing the effectiveness of the material. The prior method for removing the accumulated debris consisted of a wet washing process to remove foreign matter and particulates from the cleaning material working surface with a solvent such as isopropyl alcohol.

The particle removal method extends to cleaning and debris collection from the cleaning wafers that are used in other front end of line (FEOL) processes such as stepper, photolithography, PVD, CVD and Etch tools. In the case of cleaning devices and wafers that are used to remove foreign matter and particulates from wafer handling hardware and wafer chucks in front end of line (FEOL) semiconductor device manufacturing tools, debris during the cleaning process will accumulate on the working surface of the cleaning device or wafer. Once particles and contaminants are collected and removed from the FEOL semiconductor manufacturing tool by the cleaning wafer it should not be recycled through the FEOL tool without a surface cleaning due to the risk of the collected debris re-entering the tool. For example, the FEOL cleaning wafer is used to remove particulate causing de-focus spots in lithography tools and as the particle is removed from the tool the chance of the particle causing a de-focus re-occurrence is eliminated. The particle must not re-enter the tool on the cleaning wafer. The particle removal device is used to lift the debris from the FEOL cleaning wafer surface and after usage, the particle removal device is subsequently discarded. Similar to probe cleaning wafers, the prior method for removing the accumulated debris consisted of wet washing the cleaning material surface with a solvent such as isopropyl alcohol.

The invention is directed to a non-destructive, solvent free method of effectively removing collected debris on the cleaning material surface. The method effectively extends the lifetime of the cleaning material surface while retaining the surface tack and abrasive properties required for proper cleaning of probe card pins and wafer chucks.

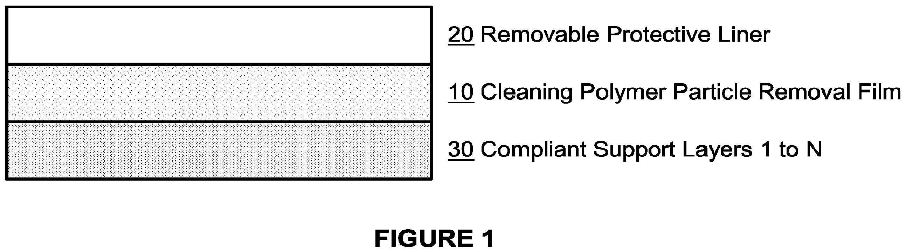

Referring now to the device used with the method in more detail, in Figure 1 there is shown a cleaning polymer, or particle removal film, 10 affixed to a plastic film backing composed of one or more intermediate layers 30 and protected by contact with a release surface coated liner film 20. In Figure 1, the plastic film backing 20 is made of one or more intermediate layers of polyethylene terephthalate (PET) or other material that allows application of the cleaning polymer during manufacturing and also allows flexing or bending during application to and removal from the cleaning material surface. The removable protective layer 20 that is installed prior to the intended usage for contact element cleaning in order to isolate the surface cleaning pad layer from non-test related contaminants. The removable protective layer 20 protects the working surface of the cleaning pad layer 202 from debris/contaminants until the cleaning device is ready to be used for cleaning a tester interface in a clean room. When the cleaning device is ready to be used for cleaning a tester interface in a clean room, the removable protective layer 20 may be removed to expose the working surface of the cleaning pad layer 10. The protective layer may be made of a known non-reactive polymeric film material and preferably made of a polyester (PET) film. The protective layer may have a matte finish or other "textured" features to improve the optical detection of the cleaning device by the testing equipment and/or improve cleaning efficiency.

Additional intermediate materials layers with predetermined properties can be used for the plastic film backing to support the cleaning polymer layer, or particle removal layer. The cleaning polymer layer 10 is comprised of an elastic polymer, such as acrylic polymer, a butadiene elastomer, a styrene copolymer elastomer, a silicone elastomer or other polymer with adhesive properties, with a controlled surface tack, or surface adhesion, and does not transfer materials. The elastic, adhesive polymer is formed on the surface of the plastic backing to produce a continuous, flexible, flat film. The polymer material is preferably an acrylic elastomer but may be silicone, rubber based or any other elastic polymer that can be formed with a surface tack property between 55 and 345 kPa. The elastic polymer material is processed to be durable under repeated handling without a reduction in surface tack or surface adhesion. The material should be sufficiently processed and/or cross-linked such that transference from the particle removal film to the cleaning material surface does not occur. The thickness of the particle removal polymer layer is preferably 0.0005 inches to 0.010 inches (0.0127 mm to 0.254 mm).

The thickness of the polymer is sufficient to allow the material to deform around the particulate on the cleaning material surface to collect debris that has accumulated during contact of the probe card pins on the cleaning material surface. A protective release film layer or liner 30 is shown which will consist of a plastic film such as polyethylene terephthalate (PET) or similar plastic material where a low surface energy coating such as silicone or fluorosilicone has been applied to allow easy removal of the protective liner from the cleaning polymer layer without transfer of material.

The one or more intermediate layers 30 (that may also be one to N compliant support layers) may be attached to and below the cleaning pad layer 10. The combinations of layers in the one or more intermediate layers 30 produce material properties unavailable from the individual constituent materials, while the wide variety of matrix, abrasive particles, and geometries allows for a product or structure that has to choose an optimum combination to maximize cleaning performance. By adding compliant or microporous foam underlayers beneath a rigid cleaning layer, the overall abrasive wear characteristics of the cleaning material are reduced and/or the tip shaping performance are enhanced in order to extend the overall service life of the probe element without compromising the shape or function of the contact geometry. For example, application of the abrasive particle layer onto a rigid polyester film creates a lapping film type cleaning material with stock removal characteristics used to create and maintain a probe contact elements with flat contact area geometries. Application of the same abrasive particle layer to the surface of a compliant unfilled polymer or the "skin" side of a microporous foam, results in multi-layered material with preferential stock removal characteristics for creating and maintaining a probe contact element with a radius or semi-radius contact area geometry. As the overall compliance of the underlayer(s) is systematically increased (or rigidity is decreased), the overall abrasive wear characteristics of the cleaning material transition from creating and maintaining a flat tip contact area geometry to creating and maintaining a radius or semi-radius contact area geometry.

The one or more intermediate layers (which can be compliant as described above, rigid as described below or a combination of compliant and rigid layers as described below) may provide predetermined mechanical, material, and dimensional characteristics to the cleaning material. For example, the one or more intermediate layers may provide abrasiveness (described in more detail below), a specific gravity (of a range of 0.75 to 2.27 for example) wherein specific gravity is the ratio of the density of the one or more intermediate layers to the density of water at a particular temperature, elasticity (of a range of 40 MPa to 600 MPa for example), tackiness ( of a range of 20 to 800 grams for example), planarity, thickness (a range between 25 µm and 300 µm for example), and/or a hardness between 30 Shore A and 90 Shore A.

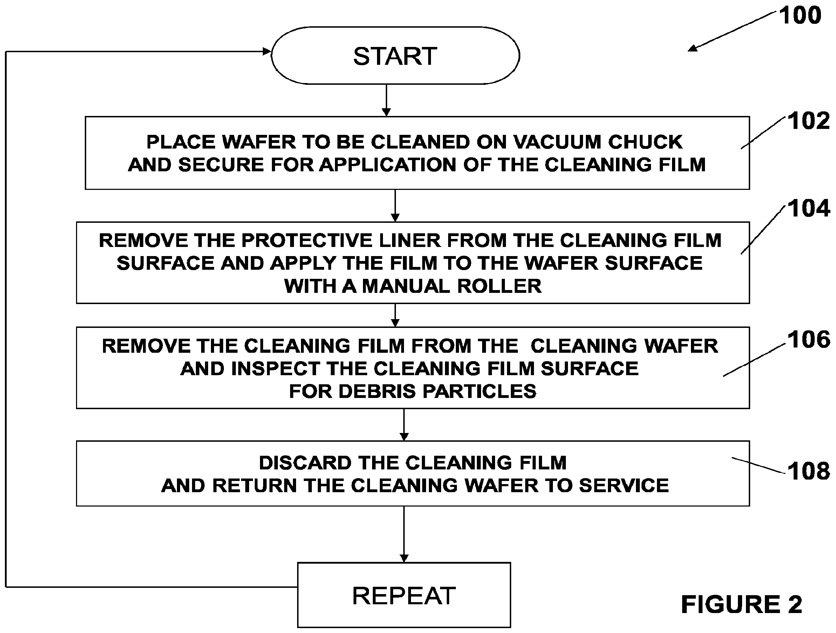

Referring to Figure 2, a flow chart is shown outlining a method 100 to use the particle removal film to remove debris from a used probe cleaning wafer or chuck cleaning wafer. In Figure 2, a probe card cleaning wafer or a FEOL tool cleaning wafer that was used to remove debris is taken out of service (i.e. removed from the prober or lithography tool) and placed on a vacuum chuck to secure the wafer in place (102). The particle removal film protective liner is removed (104) and, preferably concurrently, the particle removal film layer is laminated to the working surface of the cleaning wafer. The debris or foreign matter that has been collected on the cleaning wafer working surface through normal processing now is preferentially adhered to the cleaning film surface. Particulate debris and foreign matter gets attached to the particle removal film surface due to the greater magnitude of surface tack and adhesion force of the particle removal polymer materials. The surface tack and adhesion properties of the particle removal film surface are predetermined to range from 40 to 1600 grams such that they exceed the surface tack and adhesion properties of the cleaning polymer, which can range from 20 to 800 grams, for example. The tack or surface adhesion level of the particle removal film surface is up to 345 kPa or greater than that of the cleaning polymer and, therefore, substantially greater than that of the working surface of the cleaning polymer. As shown in Figure 2, the cleaning film also may be applied to the wafer surface with a manual roller.

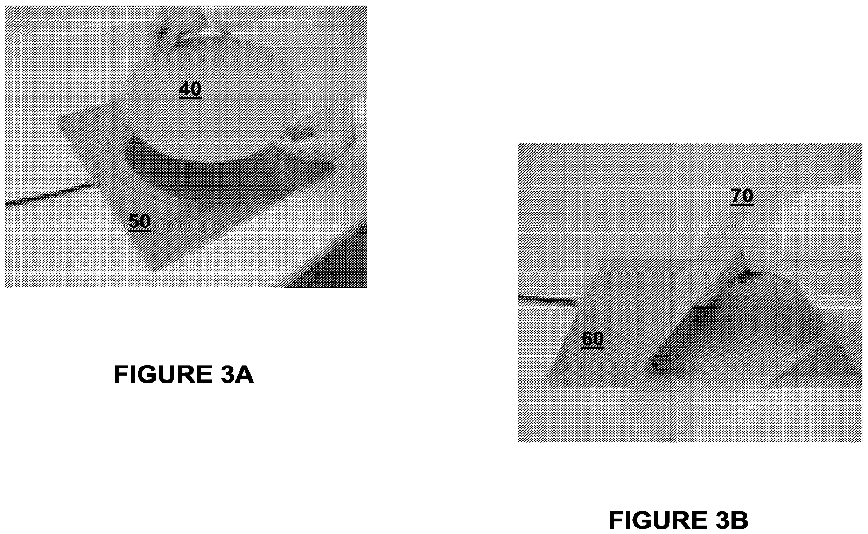

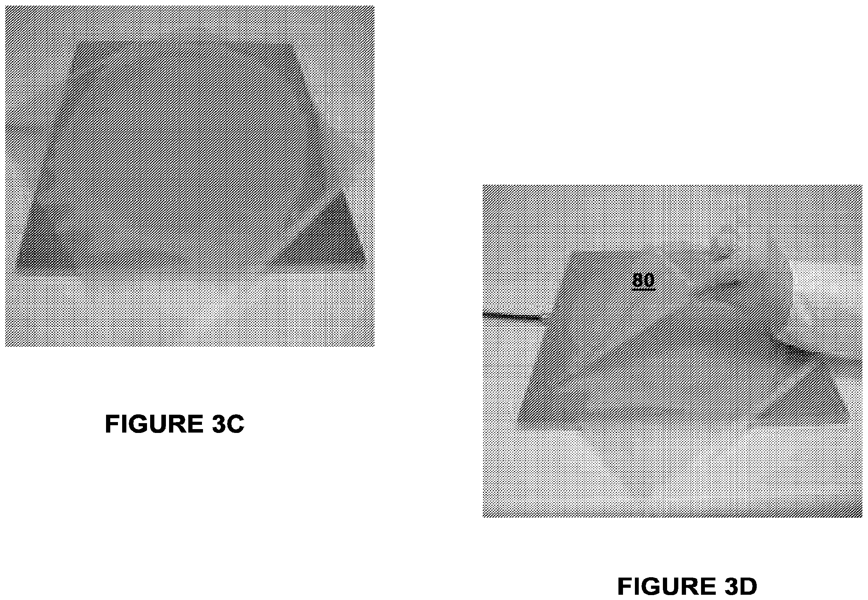

Figures 3A-3D show photographic representations of the use of the particle removal film to clean the surface of a cleaning wafer typically used for probe card cleaning or for debris removal from FEOL tools. In Figure 3A, the cleaning wafer 40 is placed on a vacuum chuck 50 to secure the wafer for application of the particle removal film. A protective liner of the removal film shown in Figure 1 is removed 60 as the particle removal film polymer 70 is applied to the working surface of the cleaning wafer as shown in Figure 3B. Debris from the working surface preferentially adheres to the particle removal film once full contact is achieved with the wafer surface as shown in Figure 3C. As the cleaning film is removed 80 as shown in Figure 3D, the debris is lifted from the cleaning wafer surface and discarded with the film.

Upon removal of the cleaning film, the trapped particulate debris and foreign matter is lifted from the cleaning wafer surface (106) and properly discarded along with the cleaning film (108). In one case, the removal of the cleaning film from the cleaning wafer surface is facilitated by the difference in surface energy level as the surface energy of the cleaning wafer is approximately 10 to 30 dyne/cm and the cleaning film polymer surface energy is approximately 40 to 60 dyne/cm. This difference prohibits adhesion and physical contact (i.e. surface wetting) between the materials and allows easy manual removal of the particle removal film. After removal of the particles from the working surface, the particle removal film is discarded along with the collected debris and foreign matter. The working surface of the cleaning wafer is now free of loose debris and can be returned to service cleaning probe card pins or semiconductor fabrication process chucks.

In one embodiment, the device cleans the working surface of a semiconductor process cleaning wafer (i.e. probe card cleaning or lithography wafer chuck cleaning). The device collects debris and foreign matter that has accumulated on the working surface of the cleaning wafer during normal usage. The debris preferentially adheres to the cleaning device allowing removal and discard. The device allows cleaning and refreshing of the cleaning wafer working surface without requiring the shipment of the wafer for refurbishing at an outside vendor. The device also eliminates the use of wet washing and the use of solvents from the wafer cleaning process.

In the method, a piece of semiconductor processing equipment (such as the probe card device or FEOL devices described above) may use a cleaning wafer the clean the piece of semiconductor processing equipment, such as the probes of a probe card. Following a plurality of cleanings, when the cleaning wafer has debris on it, the cleaning wafer is removed from the piece of semiconductor processing equipment and then cleaned as described above. Once the cleaning wafer is cleaned using the cleaning film, the cleaning wafer is returned to service in the piece of semiconductor processing equipment to be used to clean the piece of semiconductor processing equipment.

## Claims

1. A method (100) for cleaning a cleaning wafer (40) that is used to clean one of a probe card cleaning wafer and a FEOL tool cleaning wafer, the method comprising:
securing (102) a cleaning wafer (40) having a cleaning polymer, the cleaning polymer having debris embedded in a top surface of the cleaning polymer; and
applying (104) a cleaning film to the top surface of the cleaning polymer of the cleaning wafer (40) to remove debris from the top surface of the cleaning polymer of the cleaning wafer (40), and
wherein a difference in one of surface tack and adhesion force between the cleaning film and the cleaning polymer of the cleaning wafer (40) causes the debris to release from the top surface of the cleaning polymer of the cleaning wafer (40) onto the cleaning film without using a solvent, wherein the surface tack and adhesion properties of the cleaning film exceed the surface tack and adhesion properties of the cleaning polymer of the cleaning water (40).

2. The method (100) of claim 1, wherein securing the cleaning wafer (40) further comprises placing the cleaning wafer (40) on a vacuum chuck (50), or
wherein applying the cleaning film further comprises removing a protective liner (20) that covers a cleaning polymer layer of the cleaning film before applying the cleaning film to the cleaning wafer (40), or
wherein applying the cleaning film further comprises using a manual roller to apply the cleaning film to the cleaning wafer (40).

3. The method (100) of claim 1 further comprising discarding the cleaning film with the embedded debris.

4. The method (100) of claim 3 further comprising returning the cleaning wafer (40) to service after it has been cleaned using the cleaning film, optionally
wherein returning the cleaning wafer (40) to service further comprises installing the cleaning wafer (40) back into a front end of the line piece of equipment, or
wherein returning the cleaning wafer (40) to service further comprises installing the cleaning wafer (40) back into a probe card machine.

5. The method (100) of claim 1 further comprising:
cleaning a semiconductor processing piece of equipment using the cleaning wafer (40);
removing the cleaning wafer (40) from the semiconductor processing piece of equipment so that the cleaning film is applied to the top surface of the cleaning polymer of the cleaning wafer (40) to remove debris,
and
returning the cleaning wafer (40) to the semiconductor processing piece of equipment so that the semiconductor processing piece of equipment is cleaned using the cleaning wafer (40).

6. The method (100) of claim 5, wherein removing the cleaning wafer (40) further comprises placing the cleaning wafer (40) on a vacuum chuck (50), or
wherein applying the cleaning film further comprises removing a protective liner (20) that covers a cleaning polymer layer of the cleaning film before applying the cleaning film to the cleaning wafer (40), or
wherein applying the cleaning film further comprises using a manual roller to apply the cleaning film to the cleaning wafer (40).

7. The method (100) of claim 5 further comprising discarding the cleaning film with the embedded debris.

8. The method (100) of claim 7 further comprising returning the cleaning wafer (40) to service after it has been cleaned using the cleaning film, optionally
wherein returning the cleaning wafer (40) to service further comprises installing the cleaning wafer (40) back into a front end of the line piece of equipment, or
wherein returning the cleaning wafer (40) to service further comprises installing the cleaning wafer (40) back into a probe card machine.

## Patentansprüche

1. Verfahren (100) zum Reinigen eines Reinigungswafers (40), der verwendet wird, um eines von einem Probecard-Reinigungswafer und einem FEOL-Werkzeug-Reinigungswafer zu reinigen, wobei das Verfahren umfasst:
Befestigen (102) eines Reinigungswafers (40), der ein Reinigungspolymer hat, wobei das Reinigungspolymer Ablagerungen aufweist, die in einer oberen Oberfläche des Reinigungspolymers eingebettet sind; und
Aufbringen (104) eines Reinigungsfilms auf die obere Oberfläche des Reinigungspolymers des Reinigungswafers (40), um Ablagerungen von der oberen Oberfläche des Reinigungspolymers des Reinigungswafers (40) zu entfernen; und
wobei ein Unterschied in einer von der Oberflächenklebrigkeit und der Adhäsionskraft zwischen dem Reinigungsfilm und dem Reinigungspolymer des Reinigungswafers (40) bewirkt, dass sich die Ablagerungen von der oberen Oberfläche des Reinigungspolymers des Reinigungswafers (40) auf den Reinigungsfilm lösen, ohne Verwenden eines Lösungsmittels, wobei die Oberflächenklebrigkeit und die Adhäsionseigenschaften des Reinigungsfilms die Oberflächenklebrigkeit und die Adhäsionseigenschaften des Reinigungspolymers des Reinigungswafers (40) übersteigen.

2. Verfahren (100) gemäß Anspruch 1, wobei das Befestigen des Reinigungswafers (40) ferner das Platzieren des Reinigungswafers (40) auf einer Vakuumspannvorrichtung (50) umfasst, oder
wobei das Aufbringen des Reinigungsfilms ferner das Entfernen einer Schutzschicht (20) umfasst, die eine Reinigungspolymerschicht des Reinigungsfilms abdeckt, bevor der Reinigungsfilms auf dem Reinigungswafer (40) aufgebracht wird, oder
wobei das Aufbringen des Reinigungsfilms ferner das Verwenden einer manuellen Walze zum Aufbringen des Reinigungsfilms auf den Reinigungswafer (40) umfasst.

3. Verfahren (100) gemäß Anspruch 1, wobei das Verfahren ferner umfasst: Entsorgen des Reinigungsfilms mit den eingebetteten Ablagerungen.

4. Verfahren (100) gemäß Anspruch 3, wobei das Verfahren ferner umfasst: Wiederinbetriebnahme des Reinigungswafers (40), nachdem er unter Verwendung des Reinigungsfilms gereinigt worden ist,
wobei die Wiederinbetriebnahme des Reinigungswafers (40) optional ferner das Installieren des Reinigungswafers (40) zurück in ein Front-end-of-Line-Ausrüstungsstück umfasst, oder
wobei die Wiederinbetriebnahme des Reinigungswafers (40) ferner das Installieren des Reinigungswafers (40) zurück in eine Probecard-Maschine umfasst.

5. Verfahren (100) gemäß Anspruch 1, wobei das Verfahren ferner umfasst:
Reinigen eines Halbleiterbearbeitungs-Ausrüstungsstücks unter Verwendung des Reinigungswafers (40);
Entfernen des Reinigungswafers (40) von dem Halbleiterbearbeitungs-Ausrüstungsstück, so dass der Reinigungsfilm auf die obere Oberfläche des Reinigungspolymers des Reinigungswafers (40) aufgebracht wird, um Ablagerungen zu entfernen;
und Zurückführen des Reinigungswafers (40) zu dem Halbleiterbearbeitungs-Ausrüstungsstück, so dass das Halbleiterbearbeitungs-Ausrüstungsstück unter Verwendung des Reinigungswafers (40) gereinigt wird.

6. Verfahren (100) gemäß Anspruch 5, wobei das Entfernen des Reinigungswafers (40) ferner das Platzieren des Reinigungswafers (40) auf einer Vakuumspannvorrichtung (50) umfasst, oder
wobei das Aufbringen des Reinigungsfilms ferner das Entfernen einer Schutzschicht (20) umfasst, die eine Reinigungspolymerschicht des Reinigungsfilms abdeckt, bevor der Reinigungsfilm auf den Reinigungswafer (40) aufgebracht wird, oder
wobei das Aufbringen des Reinigungsfilms ferner das Verwenden einer manuellen Walze zum Aufbringen des Reinigungsfilms auf den Reinigungswafer (40) umfasst.

7. Verfahren (100) gemäß Anspruch 5, wobei das Verfahren ferner umfasst: Entsorgen des Reinigungsfilms mit den eingebetteten Ablagerungen.

8. Verfahren (100) gemäß Anspruch 7, wobei das Verfahren ferner umfasst: Wiederinbetriebnahme des Reinigungswafers (40), nachdem er unter Verwendung des Reinigungsfilms gereinigt worden ist,
wobei die Wiederinbetriebnahme des Reinigungswafers (40) optional ferner das Installieren des Reinigungswafers (40) zurück in ein Front-end-of-Line-Ausrüstungsstück umfasst, oder
wobei die Wiederinbetriebnahme des Reinigungswafers (40) ferner das Installieren des Reinigungswafers (40) zurück in eine Probecard-Maschine umfasst.

## Revendications

1. Un procédé (100) de nettoyage d'une plaquette de nettoyage (40) qui est utilisé pour nettoyer l'une parmi une plaquette de nettoyage de carte sonde et une plaquette de nettoyage d'outil FEOL, le procédé comprenant :
le fait (102) de fixer une plaquette de nettoyage (40) ayant un polymère de nettoyage, le polymère de nettoyage ayant des débris incrustés dans une surface supérieure du polymère de nettoyage ; et
le fait (104) d'appliquer un film de nettoyage sur la surface supérieure du polymère de nettoyage de la plaquette de nettoyage (40) de façon à éliminer les débris de la surface supérieure du polymère de nettoyage de la plaquette de nettoyage (40) ; et
une différence entre l'adhésivité de surface et la force d'adhérence entre le film de nettoyage et le polymère de nettoyage de la plaquette de nettoyage (40) provoquant la libération des débris de la surface supérieure du polymère de nettoyage de la plaquette de nettoyage (40) sur le film de nettoyage sans en utilisant un solvant, les propriétés d'adhésivité de surface et d'adhérence du film de nettoyage dépassant les propriétés d'adhésivité de surface et d'adhérence du polymère de nettoyage de l'ondulation de la plaquette de nettoyage (40).

2. Le procédé (100) selon la revendication 1, dans lequel la fixation de la plaquette de nettoyage (40) comprend en outre le fait de placer la plaquette de nettoyage (40) sur un mandrin à dépression (50), ou
dans lequel l'application du film de nettoyage comprend en outre le fait de retirer une pellicule protectrice (20) qui recouvre une couche de polymère de nettoyage du film de nettoyage avant d'appliquer le film de nettoyage sur la plaquette de nettoyage (40), ou
dans lequel l'application du film de nettoyage comprend en outre le fait d'utiliser un rouleau manuel pour appliquer le film de nettoyage sur la plaquette de nettoyage (40).

3. Le procédé (100) selon la revendication 1, comprenant en outre le fait de jeter le film de nettoyage avec les débris incrustés.

4. Le procédé (100) selon la revendication 3, comprenant en outre le fait de remettre en service la plaquette de nettoyage (40) après qu'elle a été nettoyée en utilisant le film de nettoyage, avec optionnellement
le fait que la remise en service de la plaquette de nettoyage (40) comprenne en outre le fait de réinstaller la plaquette de nettoyage (40) dans une extrémité avant de l'équipement de ligne, ou
le fait que la remise en service de la plaquette de nettoyage (40) comprenne en outre le fait de réinstaller la plaquette de nettoyage (40) dans une machine à carte à sonde.

5. Le procédé (100) selon la revendication 1, comprenant en outre :
le fait de nettoyer un équipement de traitement de semi-conducteur en utilisant la plaquette de nettoyage (40) ;
le fait de retirer la plaquette de nettoyage (40) de l'équipement de traitement de semi-conducteurs de sorte que le film de nettoyage soit appliqué sur la surface supérieure du polymère de nettoyage de la plaquette de nettoyage (40) afin d'éliminer les débris ; et
le fait de ramener la plaquette de nettoyage (40) sur l'équipement de traitement de semi-conducteurs de façon que l'équipement de traitement de semi-conducteurs soit nettoyé en utilisant la plaquette de nettoyage (40).

6. Le procédé (100) selon la revendication 5, dans lequel le retrait de la plaquette de nettoyage (40) comprend en outre le fait de placer la plaquette de nettoyage (40) sur un mandrin à dépression (50), ou
dans lequel l'application du film de nettoyage comprend en outre le fait de retirer une pellicule protectrice (20) qui recouvre une couche de polymère de nettoyage du film de nettoyage avant d'appliquer le film de nettoyage sur la plaquette de nettoyage (40), ou
dans lequel l'application du film de nettoyage comprend en outre le fait d'utiliser un rouleau manuel pour appliquer le film de nettoyage sur la plaquette de nettoyage (40).

7. Le procédé (100) selon la revendication 5, comprenant en outre le fait de jeter le film de nettoyage avec les débris incrustés.

8. Le procédé (100) selon la revendication 7, comprenant en outre le fait de remettre en service la plaquette de nettoyage (40) après qu'elle a été nettoyée en utilisant le film de nettoyage, avec optionnellement
le fait que la remise en service de la plaquette de nettoyage (40) comprenne en outre le fait de réinstaller la plaquette de nettoyage (40) dans une extrémité avant de l'équipement de ligne, ou
le fait que la remise en service de la plaquette de nettoyage (40) comprenne en outre le fait de réinstaller la plaquette de nettoyage (40) dans une machine à carte sonde.
